# EUROPEAN PATENT SPECIFICATION

(11) **EP 4 307 872 B1**
(45) Date of publication and mention of the grant of the patent: **09.12.2026**
(21) Application number: 22184697.5
(22) Date of filing: 13.07.2022
(51) Int. Cl.: H10N 50/10, H10N 50/01, H03K 19/18, H03K 19/23

(54) **CHIRAL SWITCHING DRIVEN SPIN TORQUE LOGIC GATES**
CHIRAL SCHALTENDE, ANGETRIEBENE SPIN-TORQUE-LOGIKGATTER
PORTES LOGIQUES À COUPLE DE SPIN COMMANDÉES PAR COMMUTATION CHIRALE

(43) Date of publication of application: 17.01.2024
(73) Proprietor: IMEC VZW, 3001 Leuven (BE); Katholieke Universiteit Leuven KU Leuven Research & Development, 3000 Leuven (BE)
(72) Inventor: NGUYEN, Van Dai, 1300 Wavre (BE); RAYMENANTS, Eline, 2820 Bonheiden (BE); COUET, Sebastien, 1390 Grez-Doiceau (BE); GAMA MONTEIRO, Maxwel, 3010 Leuven (BE); VERMEULEN, Bob, 4500 Huy (BE)
(74) Representative: Winger

(56) References cited:
- EP-A1- 3 757 997
- JOHN H. DUFFUS: "INTERNATIONAL UNION OF PURE AND APPLIED CHEMISTRY CHEMISTRY AND HUMAN HEALTH DIVISION CLINICAL CHEMISTRY SECTION, COMMISSION ON TOXICOLOGY - "HEAVY METALS"—A MEANINGLESS TERM?", vol. 74, no. 5, 1 January 2002 (2002-01-01), GB, pages 793 - 807, XP055480795, ISSN: 0033-4545, Retrieved from the Internet <URL:http://iupac.org/publications/pac/pdf/2002/pdf/7405x0793.pdf> DOI: 10.1351/pac200274050793

## Description

### Field of the invention

The invention relates to the field of logic devices. More specifically it relates to spin logic devices.

### Background of the invention

Further scaling of CMOS (complementary metal-oxide semiconductor) technology is currently approaching fundamental limits. Therefore, there is an increasing demand to identify beyond-CMOS solutions to circumvent these challenges. Spin logic devices which exploit both the electron's charge and spin to perform logic operations are currently considered as a potential replacement. Spin logic devices are expected to enable functional scaling rather than dimensional scaling thanks to their special properties, such as non-volatility, ultra-low power and small footprint. Among them, the spin torque majority gate device (STMG) has been intensely studied since the last decade. A STMG device in which an AND and an OR gate are combined in a single majority gate could potentially reduce circuit complexity and therefore revolutionize circuit design. In the original device proposal by Intel (Nikonov et al., IEEE Elec. Dev. Lett. 32, 1128 - 1130 (2011)), a functional STMG device is based on the domain wall (DW) motion in the free layer shared by multiple magnetic tunnel junction (MTJ) pillars. The simplest design of majority gates has three inputs and one output. The output turns to 'true' if more than 50% of the inputs is 'true'. In the STMG operation, DWs which are generated by spin transfer torque (STT) at each input MTJ are driven in a complex shape of conduit layer by exchange interaction to perform the logic operation. The arrival of DW at the output is probed by tunnelling magnetoresistance (TMR) at the output MTJ.

An STMG device which is based on exchange interaction driven DW motion in the free layer shared by multiple MTJ pillars requires ultra-scaled devices, since the dimension of devices is expected to be equivalent to the DW width, typically around 10 nm lateral dimension or below. High perpendicular magnetic anisotropy (PMA) materials are needed to maintain the magnetic property of devices at low dimension, but it leads to very narrow DW width and thus small device dimension. Low PMA materials have larger DW widths which potentially enlarge the process window to fabricate these devices, but low PMA materials will lose the magnetic property of devices due to the superparamagnetic effect. So far, there is no feasible solution for practical implementation of this device concept.

An STMG device may also be based on dipolar interaction. In this device concept, dipolar interaction between adjacent magnets has been proposed and demonstrated to perform majority logic operation (Imre et al., Science 311, 205-208 (2006)). However, this device proposal is difficult for scaling down at low dimension since the dipolar interaction strength is proportional to the volume of magnetic elements. Also, it is very challenging for practical implementation with full electrical control via MTJs due to the complexity of the stray field profile in the MTJ stack. Finally, an external clocking field is usually needed to assist the switching of the output.

An STMG device may also be based on spin orbit torque driven DW motion. In this concept, logic operation requires sending electrical current from every input arm to induce DW motion in a logic circuit. This operation scheme leads to a large current distribution in the output arm. As a result, it causes a failure mode of the majority operation due to random DW nucleation by Joule heating at the output and consequently reduces the reliability of the device.

An STMG device may also be based on SOT driven DW motion and chiral coupling induced DW inverter. Chiral coupling between out-of-plane and in-plane magnetic regions in a single magnetic layer via strong Dzyaloshinskii-Moriya interaction (DMI) at the interface of the ferromagnetic layer and a heavy metal has been proposed and experimentally studied by ETH and PSI (Luo et al. Science 363.6434 (2019): 1435-1439). Experimental demonstration of this concept has been performed on samples where a selective oxidization process has been used to produce magnetic out-of-plane and in-plane regions in a single magnetic layer. However, this fabrication process poses some challenges to implement with MTJs for full electrical control of nanoscale devices due to the complex multilayer magnetic structures of a MTJ stack. Reconfigurable DW logic devices based on the chiral coupling induced DW inverter has been experimentally demonstrated by ETH and PSI (Luo et al. Nature 579.7798 (2020): 214-218). This concept uses a common SOT current line to push the DW motion for logic operation, solving the current crowding issue at the output but leading to delays due to the different speeds of DW motion at every input. Indeed, in this design, the current produces different SOT on the DWs at different input arms due to the orientation of each input with respect to the SOT line. As a result, it leads to different speeds of DW motion from different inputs. Therefore, a long delay is expected to complete the logic operation. This device concept also requires an additional energy to push the DW through the in-plane region and nucleate a domain on the other side of this region. Compared to conventional integration schemes of STMG devices, additional mask sets and integration processes are needed to implement an in-plane region to enable chiral coupling between two out-of-plane magnetic regions of the DW conduit.

A further device, methods and use of the prior art are described by EP 3 757 997 A1.

In view of the problems cited above there is a need for alternative solutions for magnetic devices and logic devices comprising such magnetic devices.

### Summary of the invention

It is an object of embodiments of the present invention to provide a good magnetic device comprising a plurality of MTJ pillars and a logic device comprising such a magnetic device. It is, furthermore, an object of embodiments of the present invention to provide a method for making such a magnetic device and such a logic device.

In a first aspect embodiments of the present invention relate to a magnetic device comprising at least two MTJ pillars.

Each MTJ pillar comprises a heavy metal layer portion, a second free magnetic layer portion on the heavy metal layer portion, a spacer portion on the second free magnetic layer portion, a first free magnetic layer portion on the spacer portion, a tunnel barrier layer portion on the first free magnetic layer portion, and a fixed magnetic layer portion on the tunnel barrier layer portion.

At least the heavy metal layer portions, the second free magnetic layer portions and the spacer portions are extending between the MTJ pillars through respectively an interconnecting heavy metal layer portion, an interconnecting second free magnetic layer portion and an interconnecting spacer portion thus respectively forming a heavy metal layer, a second free magnetic layer and a spacer layer.

The interconnecting second free magnetic layer portion has an in-plane magnetization and the second free magnetic layer portions of the MTJ pillars have an out-of-plane magnetization.

It is an advantage of a magnetic device according to embodiments of the present invention that it enables chiral coupling between perpendicular MTJ pillars interconnected via an in-plane free magnetic layer. This chiral coupling will be induced by DMI at the interface of the second free magnetic layer and the heavy metal layer.

In embodiments of the present invention, the chiral coupling between the MTJ pillars interconnected via the in-plane free magnetic layer allows transferring the magnetic information between the MTJ pillars via chiral induced switching. As a result thereof no in-plane current is needed to drive the motion of domain walls (DWs) for information transmission. Therefore, it offers faster operation and lower energy consumption and overcomes the challenges related to DW motion and current crowding.

In embodiments of the present invention spin transfer torque (STT) can be applied at an MTJ pillar to locally switch its magnetization state. The change of magnetization state of an MTJ pillar may be electrically detected by tunneling magnetoresistance (TMR) read.

The spacer layer makes a structural transition between the first free magnetic layer portions and the second free magnetic layer. The thickness of the spacer layer (also referred to as interexchange layer) is tuned such that the first free magnetic layer portions and the second free magnetic layer are ferromagnetically coupled through exchange interaction.

In a second aspect embodiments of the present invention relate to a logic device comprising a magnetic device according to embodiments of the present invention. The magnetic device comprises at least four MTJ pillars. In embodiments of the present invention an odd number of pillars is used as input and another pillar is used as output. The pillars are interconnected via the interconnecting in-plane free layer. Thus, a logic device implementation of chiral switching for minority gates operation is obtained. Via STT, the magnetization state of some MTJ pillars can be controlled and the combined output can be retrieved via TMR on another MTJ pillar.

In a logic device according to embodiments of the present invention the number of MTJs may for example be exactly four. In such embodiments the arms may be positioned such that a T-shape is formed.

In a third aspect embodiments of the present invention relate to a method for manufacturing a magnetic or logic device comprising at least two MTJ pillars. The method comprises:
- providing a heavy metal layer,
- providing a second free magnetic layer on top of the heavy metal layer,
- providing a spacer layer on the second free magnetic layer,
- providing a first free magnetic layer on the spacer layer,
- providing a tunnel barrier layer on the first free magnetic layer,
- providing a fixed magnetic layer on the tunnel barrier layer,
- structuring the fixed magnetic layer such that fixed magnetic layer portions of the MTJ pillars are remaining thus subdividing the second free magnetic layer in second free magnetic layer portions underneath the fixed magnetic layer portions, and an interconnecting second free magnetic layer portion between two MTJ pillars, wherein the second free magnetic layer portions are out-of-plane magnetic regions,
   - ion beam etching and/or ion irradiation between the fixed magnetic layer portions such that the interconnecting second free magnetic layer portion has an in-plane magnetic state.

In a fourth aspect embodiments of the present invention relate to the use of a magnetic or logic device according to embodiments of the present invention. Spin transfer torque is used to drive switching of the first and the second free magnetic layer portions under one of the MTJ pillars. This induces the switching of the interconnecting second free layer portion due to chiral coupling. Tunneling magnetoresistance is used to read a magnetization of the first free magnetic layer portion of another of the MTJ pillars.

Further embodiments of the present invention are defined according to the appended dependent claims.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows a schematic drawing of a hybrid free layer stack design and of a magnetic device comprising 2 MTJ pillars and an interconnecting free magnetic layer with in-plane magnetization, in accordance with embodiments of the present invention.
FIG. 2 schematically illustrates the operation of a magnetic device, in accordance with embodiments of the present invention.
FIG. 3 shows schematic drawings of a logic device comprising 3 MTJ inputs and 1 MTJ output, in accordance with embodiments of the present invention.
FIG. 4 schematically illustrates the operation of a logic device, in accordance with embodiments of the present invention.
FIG. 5 presents the schematic of a minority logic gate driven by chiral coupling, in accordance with embodiments of the present invention.
FIG. 6 shows a flow chart of a method for manufacturing a magnetic or logic device, in accordance with embodiments of the present invention.
FIG. 7 illustrates the structuring step of a method for manufacturing a magnetic device, in accordance with embodiments of the present invention.
FIG. 8 illustrates the IBE/radiation step for creating the in-plane magnetic state of the interconnecting second free magnetic layer, of a method in accordance with embodiments of the present invention.
FIG. 9 illustrates an alternative method step for creating the in-plane magnetic state of the interconnecting second free magnetic layer, of a method in accordance with embodiments of the present invention.
FIG. 10 shows magnetic properties of a MTJ stack, for which the thickness of the second free magnetic layer is 0.67 nm.
FIG. 11 shows magnetic properties of a MTJ stack, for which the thickness of the second free magnetic layer is 0.8 nm.
FIG. 12 shows a schematic drawing of a control structure which can be used to validate the in-plane magnetization after applying the method step for obtaining the in-plane magnetization, in accordance with embodiments of the present invention.
FIG. 13 and FIG. 14 show control structures wherein one MTJ pillar is coupled with an extended in-plan free layer, in accordance with embodiments of the present invention.
FIG. 15 shows a control structure for pricing chiral coupling with 2 MTJ pillars using an in-plane magnetic field, in accordance with embodiments of the present invention.

Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In a first aspect embodiments of the present invention relate to a magnetic device 200 comprising at least two MTJ pillars 100. Each MTJ pillar 100 comprises:
- a heavy metal layer portion 110a, 110b,
- a second free magnetic layer portion 120a, 120b on the heavy metal layer portion 110a, 110b,
- a spacer portion 130a, 130b on the second free magnetic layer portion 120a, 120b,
- a first free magnetic layer portion 140a, 140b on the spacer portion 130a, 130b,
- a tunnel barrier layer portion 150a, 150b on the first free magnetic layer portion 140a, 140b,
- and a fixed magnetic layer portion 160a, 160b on the tunnel barrier layer portion 150a, 150b.

At least the heavy metal layer portions 110a, 110b, the second free magnetic layer portions 120a, 120b and the spacer portions 130a, 130b are extending between the MTJ pillars 100 through respectively an interconnecting heavy metal layer portion 110m, an interconnecting second free magnetic layer portion 120m and an interconnecting spacer portion 130m thus respectively forming a heavy metal layer 110, a second free magnetic layer 120 and a spacer layer 130.

The interconnecting second free magnetic layer portion 120m has an in-plane magnetization and the second free magnetic layer portions 120a, 120b of the MTJ pillars 100 have an out-of-plane magnetization.

In embodiments of the present invention the first free magnetic layer portions 140a, 140b are extending between the MTJ pillars 100 through an interconnecting first free magnetic layer portion 140m thus forming a first free magnetic layer 140.

In embodiments of the present invention the tunnel barrier layer portions 150a, 150b are extending between the MTJ pillars 100 through an interconnecting tunnel barrier layer portion 150m thus forming a tunnel barrier layer 150.

In embodiments of the present invention the first free magnetic layer portions 140a, 140b, the second free magnetic layer 120, and if present the interconnecting first free magnetic layer portion 140m are made of ferromagnetic material.

In embodiments of the present invention the first free magnetic layer portions 140a, 140b, and if present the interconnecting first free magnetic layer portion 140m are made of CoFeB. It is thereby an advantage of embodiments of the present invention that a good TMR signal and low STT switching current is obtained via the MTJs.

In a second aspect embodiments of the present invention relate to a logic device 300 which comprises a magnetic device 200 according to embodiments of the present invention. The magnetic device comprises at least four MTJ pillars of which an odd number of MTJ pillars is used as input and one of the MTJ pillars is used as output.

In a magnetic device according to embodiments of the present invention chiral coupling between perpendicular MTJs is implemented for full electrical control of spintronic minority gate devices. Via STT write the logic inputs are provided and via TMR readout the logic output can be read.

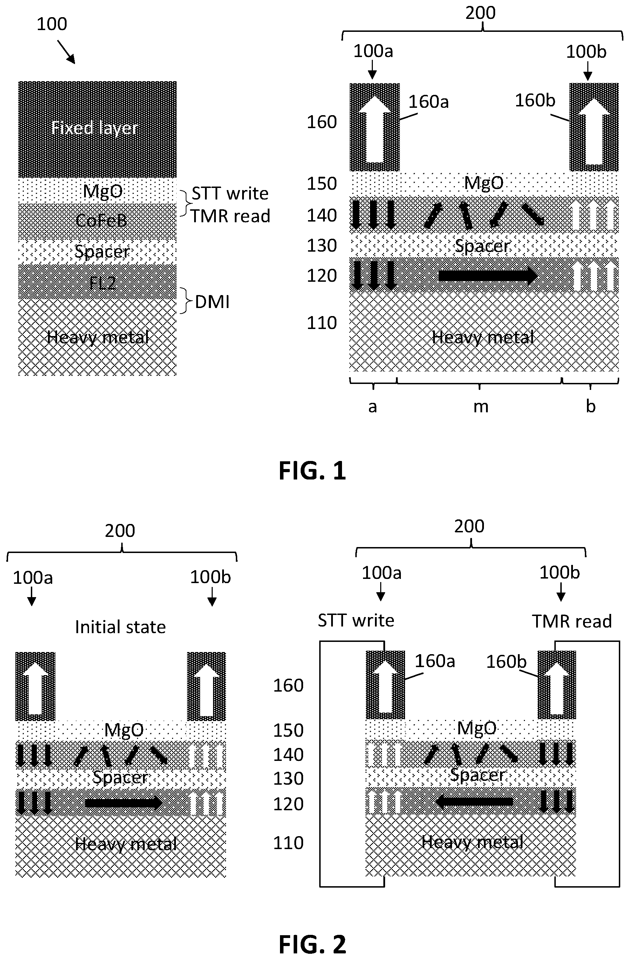

Chiral coupling between perpendicular MTJs interconnected via the interconnecting second free magnetic layer portion 120m will be induced by strong DMI between the free layer and the common heavy metal layer 110 underneath. In a simple picture, the magnetization of the free layer at the first perpendicular MTJ is strongly coupled with the second MTJ in anti-parallel arrangement due to the chiral coupling via the in-plane region as shown in the right stack of FIG. 1. In this drawing the arrows represent the direction of the magnetization in each layer of the MTJ stack. The arrows in the interconnecting first free magnetic layer portion 140m represent the magnetic state in this portion which is damaged during the device integration process.

The left figure of FIG. 1 shows a schematic drawing of a hybrid free layer stack design which is used to implement chiral coupling between 2 MTJ pillars via an interconnecting free layer 120m as shown in the right figure. The hybrid free layer design comprises an interexchange layer, also referred to as a spacer 130, sandwiched in between the first free magnetic layer 140 (e.g. a CoFeB-based free layer) and the second free magnetic layer portion free 120 (FL2) as schematically shown. The role of the first free magnetic layer 140 is to provide a good TMR signal and low STT switching current via MTJs. The spacer layer 130 is provided to make a structural transition between the first free magnetic layer 140 and the second free magnetic layer 120. The spacer layer may for example comprise Ta, W, Nb, or Mo and/or a heavy-metal-transition-metal alloy, such as TaCoFeB, WCoFeB. The thickness of the interexchange layer 130 can be tuned such that the first free magnetic layer 140 (e.g. comprising CoFeB) and the second free magnetic layer 120 are ferromagnetically (FM) coupled through exchange interaction. The thickness of the spacer layer 130 may for example range between 0.1 nm and 1 nm or more preferably between 0.2 and 0.4 nm.

The thickness of the fixed magnetic layer 160 may for example range between 10 nm and 25 nm. The thickness of the tunnel barrier layer 150 may for example range between 0.8 nm and 2 nm. The tunnel barrier layer may for example be a MgO layer. The thickness of the first free layer 140 may for example range between 0.5nm and 1nm. The thickness of the second free layer 120 may for example range between 0.5nm and 1nm. The thickness of the heavy metal layer 110 may for example range between 1nm and 10nm, preferably between 2.5nm and 3.5nm.

The magnetic state of the interconnecting second free magnetic layer portion 120m can be tuned from out-of-plane to in-plane by ion beam etching and/or ion irradiation.

The second free magnetic layer 120 may comprise Co and/or Fe, and/or CoFeB and/or any combination thereof.

The heavy metals with large spin orbit coupling may comprise any of Ir, W, Hf, Pt, Ta and will be the source providing the DMI on the second free magnetic layer 120.

In embodiments of the present invention fabrication of chiral MTJs is done by controlling the in-plane magnetic state of second free magnetic layer portion 120m via ion beam etching and/or ion irradiation processes. The out-of-plane magnetization state of the free layer portions 120a, 120b underneath of the MTJ pillars 100 will be maintained during the process due to the protection of the hard mask against etching/irradiation processes.

Chiral coupling is driven by the DMI originated from the interface of the second free layer 120 and the heavy metal layer 110. The strength and sign of chiral coupling can be controlled by the nature of DMI at the interface of the second free layer 120 and the heavy metal layer 110 in the hybrid free layer design.

The magnetization state of the MTJs 100 and the interconnecting in-plane free layer 120m are strongly correlated in order to minimize the DMI energy that originates from the interface of the second free magnetic layer 120 and the heavy metal layer 110.

In an equilibrium state, the magnetization direction of the MTJs 100 and the in-plane interconnecting free layer 120m have a unique chirality that is fixed by the nature of the DMI. Thus, the magnetization state of the MTJs and the interconnecting in-plane free layer 120m can be mutually switched. As a result, the magnetization state of an MTJ pillar 100a can be laterally controlled by STT induced switching at the adjacent MTJ pillar 100b.

The left stack of FIG. 2 shows the initial state of a basic building block of chiral MTJs, in accordance with embodiments of the present invention. STT is applied at the first MTJ pillar 100a to locally switch its magnetization state from an anti-parallel to parallel state. The right device of FIG. 2 presents chiral inverter operation where STT is used to switch the magnetic state of MTJ pillar 100a. Because of chiral coupling, the magnetization of the interconnecting in-plane region (i.e. the interconnecting second free magnetic layer portion 120m) and of the second MTJ pillar 100b will be naturally switched in the opposite direction in order to minimize the DMI energy. The change of magnetization state at the second MTJ pillar can be electrically detected by TMR read. Thus, an inverter or NOT logic gate is obtained. This is a basic building block of any logic device.

In a logic device 300 according to embodiments of the present invention the MTJ pillars may be organized in a star configuration wherein a plurality of arms are extending from a central point. The interconnecting second free magnetic layer portions 120m form the arms of the star. MTJs 100 which are used as input are positioned at outer ends of the arms and the MTJ which is used as output is positioned at the central point of the star. The logic device comprises an odd number of input MTJ pillars. Thus, a minority logic gates operation can be obtained. This corresponds with a majority gate combined with an inversion step.

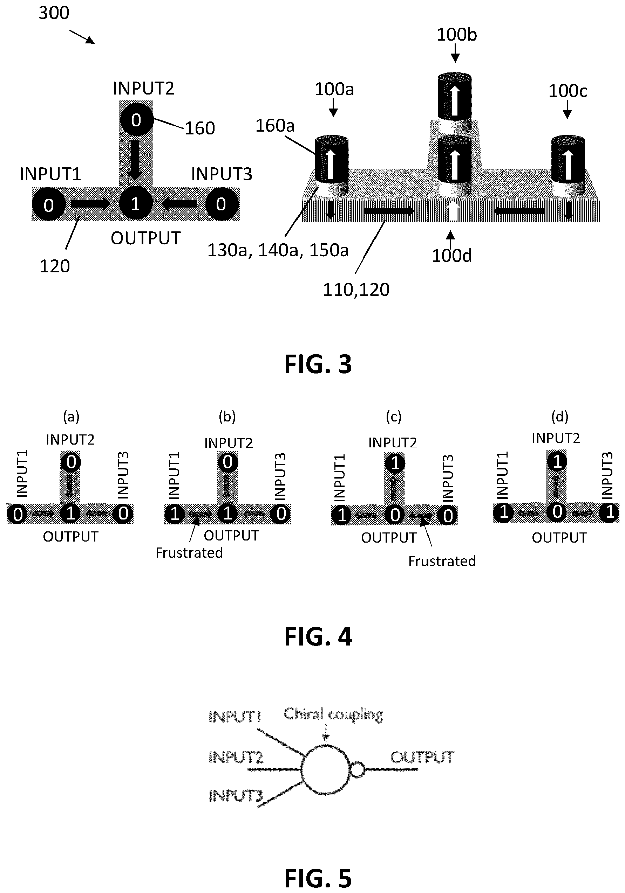

An example of such a logic device is shown in FIG. 3. The left schematic drawing shows a top view and the right schematic drawing shows a 3D-view of the stack. In this device, the logic state of inputs and outputs are fully electrically controlled via MTJs. In this example, the device proposal of chiral switching driven minority gate operation consists of 3 MTJ inputs and 1 MTJ output which are interconnected by an in-plane free layer. This corresponds with a combination of 3 inverters sharing a common output MTJ. The most basic design of the logic device is in a T-shape structure as in FIG. 3. From top to bottom the fixed magnetic layer portion 160a, the tunnel barrier layer portion 150a, the first free magnetic layer portion 140a, the spacer portion 130a are shown (the latter three are shown as one to simplify the figure). Furthermore, the second free magnetic layer 120 and the heavy metal layer 110 are shown (also these are shown as one to simplify the picture). The second free magnetic layer portions under the pillars have an out-of-plane magnetization. The interconnecting second free magnetic layer portions between the pillars have an in-plane magnetization.

In this device, the logic state is encoded in the magnetization state of the free layer underneath the pillars. The magnetization direction of the MTJs and the in-plane interconnecting free layer are fixed by the nature of the DMI at the interface between the free layer and the heavy metal.

In operation mode according to the fourth aspect of the present invention, STT is used to drive the switching of the free layer underneath the input pillar 100a, 100b, 100c which induces the switching of the interconnecting free layer due to the chiral coupling. The logic state of the output which is defined by the majority states of logic inputs will be detected by TMR at the output MTJ 100d. Therefore, this logic gate can be reconfigured as a minority operation where the logic state of inputs and outputs are fully electrically controlled via MTJs. In such a minority logic gate the output is only switched if more than 50% of the inputs are switched. Actually, the output is only switched if majority states of logic inputs are switched. Since the input and output are always in opposite logic states, therefore, this majority operation forms a minority logic gate

It is an advantage of a logic device according to embodiments of the present invention that it has a fast operation and low energy consumption compared to devices which are based on SOT driven DW motion. Indeed, the operation of chiral logic devices according to embodiments of the present invention is no longer based on the SOT driven DW motion, avoiding any issues related to DW pinning and the use of in-plane current.

In embodiments of the present invention the magnetic state of the interconnecting free layer is precisely controlled to be in-plane. No additional mask or processes are needed to define the in-plane region.

Fig. 4 presents the representative operation of a logic device comprising three input MTJs and one output MTJ, in accordance with embodiments of the present invention.

FIG. 4a shows the initial state, the logic state of the inputs is set to be 0 and thus the logic output is naturally 1 due to the chiral coupling.

In FIG. 4b, STT is applied at one of the inputs, thus INPUT1 is switched from 0 to 1. In this operation, the logic output will be maintained at logic state 1 since it is set by chiral coupling from INPUT2 and the INPUT3. The magnetic state of the in-plane free layer between INPUT1 and OUTPUT will be in a frustrated state.

In FIG. 4c, STT is applied at 2 inputs. INPUT1 and INPUT2 are switched from 0 to 1. In this operation, the logic state of OUTPUT will be switched from 1 to 0 since it is driven by chiral coupling from INPUT1 and INPUT2. The magnetic state of the in-plane free layer between INPUT3 and OUTPUT will be in a frustrated state.

In FIG. 4d, STT is applied at all 3 inputs. In this example all INPUTs are switched from 0 to 1. In this operation, the logic state of the OUTPUT will be switched from 1 to 0 since it is driven by chiral coupling from all the inputs. There is no frustrated state of the in-plane free layer in this operation.

By the combination of all possible logic inputs, a logic truth table for the reconfigurable NAND and NOR logic operations can be built based on the logic device, according to embodiments of the present invention.

FIG. 5 presents the schematic of a minority logic gate driven by chiral coupling, in accordance with embodiments of the present invention. The truth table of this logic gate with 3 inputs is shown below.

| INPUT1 | INPUT2 | INPUT3 | OUTPUT |
|---|---|---|---|
| 0 | 0 | 0 | 1 |
| 0 | 0 | 1 | 1 |
| 0 | 1 | 0 | 1 |
| 0 | 1 | 1 | 0 |
| 1 | 0 | 0 | 1 |
| 1 | 0 | 1 | 0 |
| 1 | 1 | 0 | 0 |
| 1 | 1 | 1 | 0 |

In a third aspect embodiments of the present invention relate to a method 400 for manufacturing a magnetic or logic device which comprises at least two MTJ pillars.

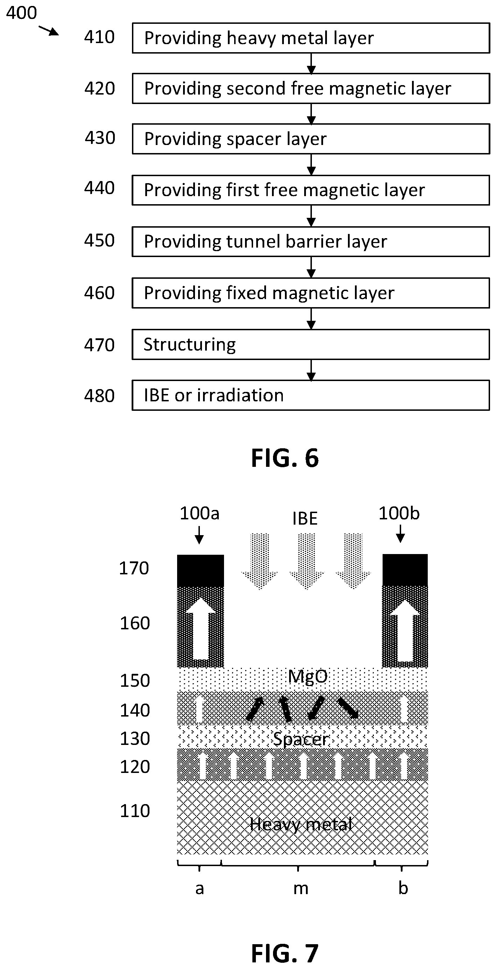

An exemplary flow chart of such a method 400 is shown in FIG. 6. The method comprises:
Providing 410 a heavy metal layer 110.
Providing 420 a second free magnetic layer 120 on top of the heavy metal layer 110.
Providing 430 a spacer layer 130 on the second free magnetic layer 120.
Providing 440 a first free magnetic layer 140 on the spacer layer 130.
Providing 450 a tunnel barrier layer 150 on the first free magnetic layer 140.
Providing 460 a fixed magnetic layer 160 on the tunnel barrier layer 150.

Structuring 470 the fixed magnetic layer 160 such that fixed magnetic layer portions 160a, 160b of the MTJ pillars 100 are remaining. Structuring may be done by removing parts of the fixed magnetic layer 460. This may for example be achieved by etching. An example thereof is illustrated in FIG. 7. In this example a hardmask 170 is provided that is used to pattern the pillars and the pillars are obtained by ion beam etching. By structuring 470, the second free magnetic layer 120 is subdivided in second free magnetic layer portions 120a, 120b underneath the fixed magnetic layer portions 160a, 160b, and an interconnecting second free magnetic layer portion 120m between two MTJ pillars 100. The second free magnetic layer portions 120a, 120b are out-of-plane magnetic regions. In embodiments of the present invention the obtained pillars may for example have a width between 10 and 100 nm, for example 50 nm. The pillar width should be limited to a maximum because it becomes harder to switch if they are too large. The spacing between the pillars may for example range between 20 and 100 nm, the spacing may for example be 50 nm. The maximum length should thereby be such that the in-plane magnetization can be flipped entirely. This distance is limited by the distance over which chiral interaction can be strong enough (should preferably be below 100nm).

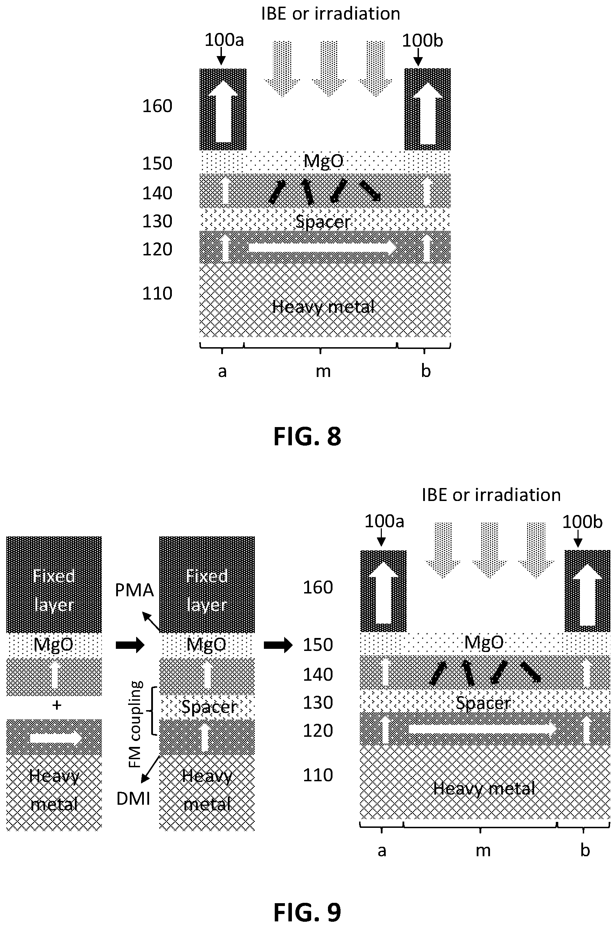

In a method according to embodiments of the present invention ion beam etching and/or ion irradiation processes 480 is applied between the fixed magnetic layer portions 160a, 160b to convert the magnetic state of the interconnecting second free magnetic layer portion 120m from PMA to in-plane to enable chiral coupled MTJs devices. This is illustrated in FIG. 8 which shows that as a result of the IBE or irradiation an in-plane magnetic state is obtained for the interconnecting second free magnetic layer portion compared to the out-of-plane magnetization in FIG. 7.

Structuring may be done deeper into the layered stack, for example into the tunnel barrier layer 450, or even into the first free magnetic layer 440, or even into the spacer layer 430.

In embodiments of the present invention the first free magnetic layer portion is PMA thanks to interfacial PMA at the interface between the first free layer and the tunnel barrier layer (e.g. CoFeB/MgO).

In an alternative method according to embodiments of the present invention the interconnecting second free magnetic layer portion is designed to have an in-plane magnetic anisotropy as standalone stack as illustrated in FIG. 9. This may for example be achieved by tuning the thickness of the second free layer (which may for example be a Co layer).

Within an MTJ pillar the PMA of the first free layer portion enforces the PMA of the second free magnetic layer portion via ferromagnetic coupling of spacer material. In embodiments of the present invention, without the ferromagnetic coupling with an out-of-plane first free layer, the second free magnetic layer portion would be in-plane.

During the device fabrication process to pattern the MTJ pillars, the interface of the interconnecting tunnel barrier portion and the interconnecting first free magnetic layer portion are damaged by ion beam etching 480. This leads to the loss of interfacial PMA of the interconnecting tunnel barrier/first free magnetic layer. Without any support for the PMA of the tunnel barrier/first free magnetic layer, the interconnecting second free magnetic layer portion 120m/interconnecting heavy metal layer portion 110m becomes in-plane.

Using such a method, in accordance with embodiments of the present invention, chiral coupling is implemented in interconnected MTJs using a hybrid free layer stack design for full electrical control of nanoscale spintronic devices. Logic devices, according to embodiments of the present invention, are scalable and implementable using current MRAM technology.

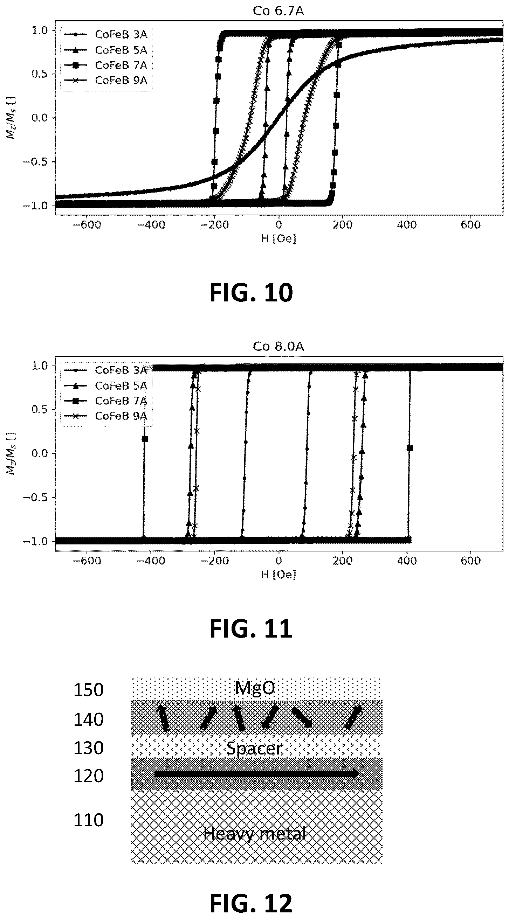

The graphs of FIG. 10 and FIG. 11 shows how the MTJ stacks can be designed. In both graphs the curves show Mz/Ms [] in function of a magnetic field H [Oe] (1 Oe = 1000 / 4π A/m ≈ 79.58 A/m) for different thicknesses of the first free magnetic layer portion (0.3 nm, 0.5 nm, 0.7 nm, 0.9 nm). Mz is the measured magnetization in the z-direction (orthogonal to the layers of the MTJ stack) and Ms is the saturation magnetization. For both graphs the first free magnetic layer is a CoFeB layer, the second free magnetic layer is a Co layer and the heavy metal layer is a Pt layer.

For the curves in FIG. 10 the thickness of the second free magnetic layer is 0.67nm. Without ferromagnetic coupling this results in an in-plane magnetization of the Pt/Co. With ferromagnetic coupling with the first free magnetic layer, the stack is PMA for a limited number of thicknesses of the first free magnetic layer (not anymore for a thickness of the first free magnetic layer of 0.3 nm). The stack is only PMA if CoFeB/MgO is PMA. The optimal PMA is in this example obtained with a thickness of the first free magnetic layer of 0.7 nm.

For the curves in FIG. 11 the thickness of the second free magnetic layer is 0.8nm. In this case the stack is PMA for all tested thicknesses of the first free magnetic layer. Between the different thicknesses the coercivity changes, but the squareness of the loop is present for each of them.

In embodiments of the present invention the thickness of the second free magnetic layer is selected such that it has an in-plane magnetic state in the absence of a ferromagnetic coupling with a first free magnetic layer portion which is PMA, and such that the second free magnetic layer is PMA in the presence of ferromagnetic coupling with a first free magnetic layer portion which is PMA. The optimal thicknesses are dependent on the material choices and can be designed using magnetic hysteresis loop measurements as illustrated in FIG. 10 and FIG. 11.

As explained earlier, the in-plane magnetization of the interconnecting second free magnetic layer portion can be obtained by IBE or irradiation on the exposed part of the tunnel barrier layer between the pillars. This leads to the loss of interfacial PMA of the interconnecting tunnel barrier/first free magnetic layer and as a result thereof to in-plane magnetization of the interconnecting second free magnetic layer portion. This can be validated using the control structure illustrated in FIG. 12. Using such a control structure the in-plane magnetic state of the control structure can be measured using anisotropic magnetoresistance which is well known in spintronics. This allows to validate the process to control the magnetic state from PMA to in-plane.

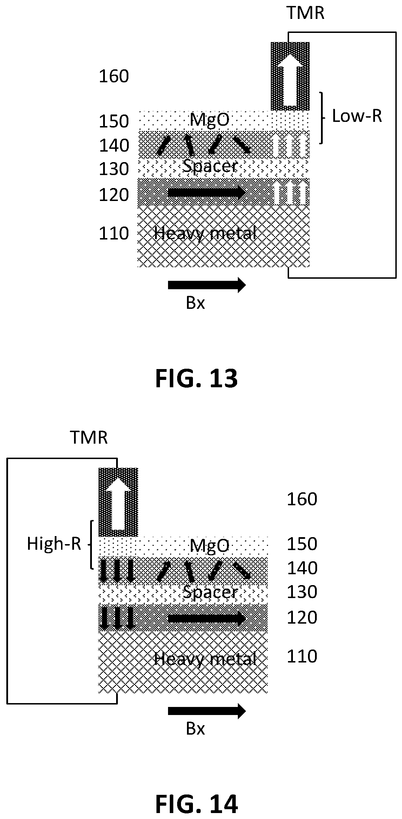

Chiral coupling using in-plane magnetic field can be validated using other control structures. These are illustrated in FIG. 13, FIG. 14, and FIG. 15. FIG. 13 and FIG. 14 show stacks wherein one MTJ pillar is coupled with an extended in-plane free layer. In case of a saturated state of the extended free layer and in case the chirality exists, the resistance state of the MTJ pillar in FIG. 13 is opposite from the resistance state in FIG. 14. In FIG. 13 the resistance state is a low resistance state and in FIG. 14 the resistance state is a high resistance state. Hence, by measuring the resistance, the existence of the chiral coupling can be verified. The resistance state will be reversed when reversing the direction of the magnetic in-plane field.

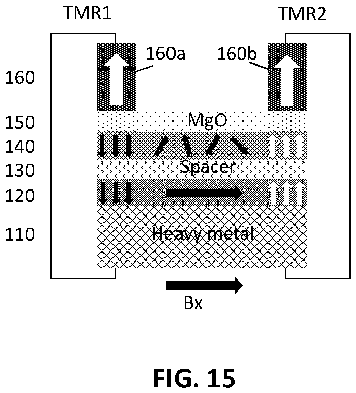

Also in a magnetic device with two MTJ pillars the chiral coupling using an in-plane magnetic field can be proven. This is illustrated in FIG. 15. In the illustration the in-plane magnetic state points in the same direction as the in-plane field Bx. If the chiral coupling is maintained, the resistance state of the MTJ will be changed by flipping the magnetic state of the interconnecting second in-plane free layer.

Using an STT driven chiral switching process full electrical control of a logic device in accordance with embodiments of the present invention can be achieved.

It is advantageous that the logic minority operation of the logic device is no longer based on the motion of DWs. Therefore, it offers very fast operation and very low energy consumption and overcomes the challenges related to DW motion and current crowding in the current design of STMG devices. In a logic device according to embodiments of the present invention the operation speed only depends on STT switching and chiral switching times.

## Claims

1. A magnetic device (200) comprising at least two magnetic tunnel junction pillars (100), each magnetic tunnel junction pillar (100) comprising a heavy metal layer portion (110a, 110b), a second free magnetic layer portion (120a, 120b) on the heavy metal layer portion (110a, 110b), a spacer portion (130a, 130b) on the second free magnetic layer portion (120a, 120b), a first free magnetic layer portion (140a, 140b) on the spacer portion (130a, 130b), a tunnel barrier layer portion (150a, 150b) on the first free magnetic layer portion (140a, 140b), and a fixed magnetic layer portion (160a, 160b) on the tunnel barrier layer portion (150a, 150b),
wherein at least the heavy metal layer portions (110a, 110b), the second free magnetic layer portions (120a, 120b) and the spacer portions (130a, 130b) are extending between the magnetic tunnel junction pillars (100) through respectively an interconnecting heavy metal layer portion (110m), an interconnecting second free magnetic layer portion (120m) and an interconnecting spacer portion (130m) thus respectively forming a heavy metal layer (110), a second free magnetic layer (120) and a spacer layer (130), wherein the heavy metal layer (110) comprises Ir, W, and/or Hf, and/or Pt, and/or Ta,
**characterised in that**
the interconnecting second free magnetic layer portion (120m) is an in-plane free magnetic layer and the second free magnetic layer portions (120a, 120b) of the magnetic tunnel junction pillars (100) have an out-of-plane magnetization.

2. A magnetic device (200) according to claim 1, wherein the first free magnetic layer portions (140a, 140b) are extending between the magnetic tunnel junction pillars (100) through an interconnecting first free magnetic layer portion (140m) thus forming a first free magnetic layer (140).

3. A magnetic device (200) according to claim 2, wherein the tunnel barrier layer portions (150a, 150b) are extending between the magnetic tunnel junction pillars (100) through an interconnecting tunnel barrier layer portion (150m) thus forming a tunnel barrier layer (150).

4. A magnetic device (200) according to any of the previous claims wherein the first free magnetic layer portions (140a, 140b), the second free magnetic layer (120), and if present the interconnecting first free magnetic layer portion (140m) are made of ferromagnetic material.

5. A magnetic device (200) according to any of the previous claims wherein the first free magnetic layer portions (140a, 140b), and if present the interconnecting first free magnetic layer portion (140m) are made of CoFeB.

6. A magnetic device (200) according to any of the previous claims wherein the second free magnetic layer (120) comprises Co and/or Fe, CoFeB and/or any combination thereof.

7. A magnetic device (200) according to any of the previous claims wherein the spacer layer (130) comprises Ta, W, Nb, or Mo and/or a heavy-metal-transition-metal alloy, such as TaCoFeB, WcoFeB.

8. A magnetic device (200) according to any of the previous claims wherein the thickness of the spacer layer (130) is between 0.1 nm and 1nm.

9. A magnetic device (200) according to any of the previous claims wherein the tunnel barrier layer portions (150a, 150b), and if present the interconnecting tunnel barrier layer portion (150m), comprise MgO.

10. A logic device (300) comprising a magnetic device (200) according to any of the previous claims, the magnetic device comprising at least four magnetic tunnel junction pillars.

11. A logic device (300) according to claim 10, wherein the magnetic tunnel junction pillars organized in a star configuration comprising a plurality of arms extending from a central point, wherein the interconnecting second free magnetic layer portions (120m) form the arms of the star, and wherein input magnetic tunnel junctions (100) are positioned at outer ends of the arms, and an output magnetic tunnel junction (100) is positioned at the central point of the star.

12. A method (400) for manufacturing a magnetic or logic device comprising at least two magnetic tunnel junction pillars (100), the method comprising:
- providing (410) a heavy metal layer (110), wherein the heavy metal layer (110) comprises Ir, W, and/or Hf, and/or Pt, and/or Ta,
- providing (420) a second free magnetic layer (120) on top of the heavy metal layer (110),
- providing (430) a spacer layer (130) on the second free magnetic layer (120),
- providing (440) a first free magnetic layer (140) on the spacer layer (130),
- providing (450) a tunnel barrier layer (150) on the first free magnetic layer (140),
- providing (460) a fixed magnetic layer (160) on the tunnel barrier layer (150),
- structuring (470) the fixed magnetic layer (160) such that fixed magnetic layer portions (160a, 160b) of the magnetic tunnel junction pillars (100) are remaining thus subdividing the second free magnetic layer (120) in second free magnetic layer portions (120a, 120b) underneath the fixed magnetic layer portions (160a, 160b), and an interconnecting second free magnetic layer portion (120m) between two magnetic tunnel junction pillars (100), wherein the second free magnetic layer portions (120a, 120b) are out-of-plane magnetic regions,
**characterised by**
- ion beam etching and/or ion irradiation (480) between the fixed magnetic layer portions (160a, 160b) such that the interconnecting second free magnetic layer portion (120m) is an in-plane free magnetic layer.

13. A method according to claim 12 the method wherein the structuring is done into the tunnel barrier layer (150) or even into the first free magnetic layer (140).

14. Use of a magnetic device (200) according to any of the claims 1 to 9 or a logic device (300) according to any of the claims 10 or 11, wherein spin torque transfer is used to drive switching of the first (140a) and the second (120a) free magnetic layer portions under one of the magnetic tunnel junction pillars (100) which induces the switching of the interconnecting second free layer portion (120m) due to chiral coupling, and wherein tunneling magnetoresistance is used to read a magnetization of the first free magnetic layer portion (140b) of another of the magnetic tunnel junction pillars (100).

## Patentansprüche

1. Magnetische Vorrichtung (200), die mindestens zwei magnetische Tunnelübergangssäulen (100) umfasst, wobei jede magnetische Tunnelübergangssäule (100) einen Schwermetallschichtabschnitt (110a, 110b), einen zweiten freien Magnetschichtabschnitt (120a, 120b) auf dem Schwermetallschichtabschnitt (110a, 110b), einen Abstandshalterabschnitt (130a, 130b) auf dem zweiten freien Magnetschichtabschnitt (120a, 120b), einen ersten freien Magnetschichtabschnitt (140a, 140b) auf dem Abstandshalterabschnitt (130a, 130b), einen Tunnelbarrierenschichtabschnitt (150a, 150b) auf dem ersten freien Magnetschichtabschnitt (140a, 140b) und einen festen Magnetschichtabschnitt (160a, 160b) auf dem Tunnelbarrierenschichtabschnitt (150a, 150b) umfasst,
- wobei sich mindestens die Schwermetallschichtabschnitte (110a, 110b), die Abschnitte der zweiten freien Magnetschicht (120a, 120b) und die Abstandshalterabschnitte (130a, 130b) zwischen den Säulen (100) des magnetischen Tunnelübergangs durch jeweils einen verbindenden Schwermetallschichtabschnitt (110m), einen verbindenden Abschnitt des zweiten freien Magnetschichtabschnitts (120m) und einen verbindenden Abstandshalterabschnitt (130m) erstrecken und daher jeweils eine Schwermetallschicht (110), eine zweite freie Magnetschicht (120) und eine Abstandshalterschicht (130) bilden, wobei die Schwermetallschicht (110) Ir, W, und/oder Hf und/oder Pt und/oder Ta umfasst,
- **dadurch gekennzeichnet, dass** der verbindende zweite freie Magnetschichtabschnitt (120m) eine in der Ebene liegende freie Magnetschicht ist, und die zweiten freien Magnetschichtabschnitte (120a, 120b) der magnetischen Tunnelübergangssäulen (100) eine Magnetisierung senkrecht zu der Ebene aufweisen.

2. Magnetische Vorrichtung (200) nach Anspruch 1, wobei sich die ersten freien Magnetschichtabschnitte (140a, 140b) zwischen den Säulen des magnetischen Tunnelübergangs (100) durch einen verbindenden ersten freien Magnetschichtabschnitt (140m) erstrecken und daher eine erste freie Magnetschicht (140) bilden.

3. Magnetische Vorrichtung (200) nach Anspruch 2, wobei sich die Tunnelbarrierenschichtabschnitte (150a, 150b) zwischen den magnetischen Tunnelübergangssäulen (100) durch einen verbindenden Tunnelbarrierenschichtabschnitt (150m) erstrecken und daher eine Tunnelbarrierenschicht (150) bilden.

4. Magnetische Vorrichtung (200) nach einem der vorstehenden Ansprüche, wobei die ersten freien Magnetschichtabschnitte (140a, 140b), die zweite freie Magnetschicht (120) und, falls vorhanden, der verbindende erste freie Magnetschichtabschnitt (140m) aus ferromagnetischem Material hergestellt sind.

5. Magnetische Vorrichtung (200) nach einem der vorstehenden Ansprüche, wobei die ersten freien Magnetschichtabschnitte (140a, 140b) und, falls vorhanden, der verbindende erste freie Magnetschichtabschnitt (140m) aus CoFeB hergestellt sind.

6. Magnetische Vorrichtung (200) nach einem der vorstehenden Ansprüche, wobei die zweite freie Magnetschicht (120) Co und/oder Fe, CoFeB und/oder jede beliebige Kombination davon umfasst.

7. Magnetische Vorrichtung (200) nach einem der vorstehenden Ansprüche, wobei die Abstandsschicht (130) Ta, W, Nb oder Mo und/oder eine Schwermetall-Übergangsmetall-Legierung wie TaCoFeB, WcoFeB umfasst.

8. Magnetische Vorrichtung (200) nach einem der vorstehenden Ansprüche, wobei die Dicke der Abstandsschicht (130) zwischen 0,1 nm und 1 nm liegt.

9. Magnetische Vorrichtung (200) nach einem der vorstehenden Ansprüche, wobei die Tunnelbarrierenschichtabschnitte (150a, 150b) und, falls vorhanden, der verbindende Tunnelbarrierenschichtabschnitt (150m) MgO umfassen.

10. Logikvorrichtung (300), die eine magnetische Vorrichtung (200) nach einem der vorstehenden Ansprüche umfasst, wobei die magnetische Vorrichtung mindestens vier magnetische Tunnelübergangssäulen umfasst.

11. Logikvorrichtung (300) nach Anspruch 10, wobei die magnetischen Tunnelübergangssäulen in einer Sternkonfiguration angeordnet sind, die eine Vielzahl von Armen umfasst, die sich von einem Mittelpunkt erstrecken, wobei die verbindenden zweiten freien Magnetschichtabschnitte (120m) die Arme des Sterns bilden, und wobei magnetische Eingangs-Tunnelübergänge (100) an den äußeren Enden der Arme positioniert sind und ein magnetischer Ausgangs-Tunnelübergang (100) an dem Mittelpunkt des Sterns positioniert ist.

12. Verfahren (400) zum Herstellen einer magnetischen oder logischen Vorrichtung, die mit mindestens zwei magnetische Tunnelübergangssäulen (100) umfasst, wobei das Verfahren Folgendes umfasst:
- Bereitstellen (410) einer Schwermetallschicht (110), wobei die Schwermetallschicht (110) Ir, W, und/oder Hf, und/oder Pt, und/oder Ta umfasst,
- Bereitstellen (420) einer zweiten freien Magnetschicht (120) auf der Schwermetallschicht (110),
- Bereitstellen (430) einer Abstandshalterschicht (130) auf der zweiten freien Magnetschicht (120),
- Bereitstellen (440) einer ersten freien Magnetschicht (140) auf der Abstandshalterschicht (130),
- Bereitstellen (450) einer Tunnelbarrierenschicht (150) auf der ersten freien Magnetschicht (140),
- Bereitstellen (460) einer festen Magnetschicht (160) auf der Tunnelbarrierenschicht (150),
- Strukturieren (470) der festen Magnetschicht (160) derart, dass die festen Magnetschichtabschnitte (160a, 160b) an den magnetischen Tunnelübergangssäulen (100) erhalten bleiben und daher die zweite freie Magnetschicht (120) in zweite freie Magnetschichtabschnitte (120a, 120b) unterhalb der festen Magnetschichtabschnitte (160a, 160b) sowie einen verbindenden zweiten freien Magnetschichtabschnitt (120m) zwischen zwei magnetischen Tunnelübergangsäulen (100) unterteilt wird, wobei es sich bei den zweiten freien Magnetschichtabschnitten (120a, 120b) um magnetische Bereiche senkrecht zu der Ebene handelt, **gekennzeichnet durch**
- Ionenstrahlätzen und/oder Ionenbestrahlung (480) zwischen den festen Magnetschichtabschnitten (160a, 160b) derart, dass der verbindende zweite freie Magnetschichtabschnitt (120m) eine freie magnetische Schicht mit Magnetisierung in der Ebene ist.

13. Verfahren nach Anspruch 12, wobei das Strukturieren in die Tunnelbarrierenschicht (150) oder sogar in die erste freie Magnetschicht (140) erfolgt.

14. Verwendung einer magnetischen Vorrichtung (200) nach einem der Ansprüche 1 bis 9 oder einer logischen Vorrichtung (300) nach einem der Ansprüche 10 oder 11, wobei Spin-Drehmoment-Transfer verwendet wird, um das Schalten des ersten (140a) und des zweiten (120a) freien Magnetschichtabschnitts unter einem der magnetischen Tunnelübergangspfeiler (100) anzutreiben, was aufgrund chiraler Kopplung das Schalten des verbindenden zweiten freien Schichtabschnitts (120m) induziert, und wobei die Tunnelmagnetoresistenz zum Auslesen einer Magnetisierung des ersten freien Magnetschichtabschnitts (140b) einer anderen der magnetischen Tunnelübergangssäulen (100) verwendet wird.

## Revendications

1. Dispositif magnétique (200) comprenant au moins deux piliers de jonction tunnel magnétique (100), chaque pilier de jonction tunnel magnétique (100) comprenant une portion de couche de métal lourd (110a, 110b), une portion de deuxième couche magnétique libre (120a, 120b) sur la portion de couche de métal lourd (110a, 110b), une portion d'espaceur (130a, 130b) sur la portion de deuxième couche magnétique libre (120a, 120b), une portion de première couche magnétique libre (140a, 140b) sur la portion d'espaceur (130a, 130b), une portion de couche de barrière tunnel (150a, 150b) sur la portion de première couche magnétique libre (140a, 140b), et une portion de couche magnétique fixe (160a, 160b) sur la portion de couche de barrière tunnel (150a, 150b),
dans lequel au moins les portions de couche de métal lourd (110a, 110b), les portions de deuxième couche magnétique libre (120a, 120b) et les portions d'espaceur (130a, 130b) s'étendent entre les piliers de jonction tunnel magnétique (100) par, respectivement, une portion de couche de métal lourd d'interconnexion (110m), une portion de deuxième couche magnétique libre d'interconnexion (120m) et une portion d'espaceur d'interconnexion (130m), formant ainsi respectivement une couche de métal lourd (110), une deuxième couche magnétique libre (120) et une couche d'espaceur (130), dans lequel la couche de métal lourd (110) comprend de l'Ir, du W, et/ou du Hf, et/ou du Pt, et/ou du Ta,
**caractérisé en ce que**
la portion de deuxième couche magnétique libre d'interconnexion (120m) est une couche magnétique libre dans le plan et les portions de deuxième couche magnétique libre (120a, 120b) des piliers de jonction tunnel magnétique (100) présentent une aimantation hors plan.

2. Dispositif magnétique (200) selon la revendication 1, dans lequel les portions de première couche magnétique libre (140a, 140b) s'étendent entre les piliers de jonction tunnel magnétique (100) par une portion de première couche magnétique libre d'interconnexion (140m), formant ainsi une première couche magnétique libre (140).

3. Dispositif magnétique (200) selon la revendication 2, dans lequel les portions de couche de barrière tunnel (150a, 150b) s'étendent entre les piliers de jonction tunnel magnétique (100) par une portion de couche de barrière tunnel d'interconnexion (150m), formant ainsi une couche de barrière tunnel (150).

4. Dispositif magnétique (200) selon l'une quelconque des revendications précédentes, dans lequel les portions de première couche magnétique libre (140a, 140b), la deuxième couche magnétique libre (120) et, si elle est présente, la portion de première couche magnétique libre d'interconnexion (140m) sont réalisées en matériau ferromagnétique.

5. Dispositif magnétique (200) selon l'une quelconque des revendications précédentes, dans lequel les portions de première couche magnétique libre (140a, 140b) et, si elle est présente, la portion de première couche magnétique libre d'interconnexion (140m) sont réalisées en CoFeB.

6. Dispositif magnétique (200) selon l'une quelconque des revendications précédentes, dans lequel la deuxième couche magnétique libre (120) comprend du Co et/ou du Fe, du CoFeB et/ou toute combinaison de ceux-ci.

7. Dispositif magnétique (200) selon l'une quelconque des revendications précédentes, dans lequel la couche d'espaceur (130) comprend du Ta, du W, du Nb ou du Mo et/ou un alliage métal lourd-métal de transition, tel que TaCoFeB, WcoFeB.

8. Dispositif magnétique (200) selon l'une quelconque des revendications précédentes, dans lequel l'épaisseur de la couche d'espaceur (130) est comprise entre 0,1 nm et 1 nm.

9. Dispositif magnétique (200) selon l'une quelconque des revendications précédentes, dans lequel les portions de couche de barrière tunnel (150a, 150b) et, si elle est présente, la portion de couche de barrière tunnel d'interconnexion (150m) comprennent du MgO.

10. Dispositif logique (300) comprenant un dispositif magnétique (200) selon l'une quelconque des revendications précédentes, le dispositif magnétique comprenant au moins quatre piliers de jonction tunnel magnétique.

11. Dispositif logique (300) selon la revendication 10, dans lequel les piliers de jonction tunnel magnétique sont organisés en une configuration en étoile comprenant une pluralité de bras s'étendant à partir d'un point central, dans lequel les portions de deuxième couche magnétique libre d'interconnexion (120m) forment les bras de l'étoile, et dans lequel des jonctions tunnel magnétiques d'entrée (100) sont positionnées aux extrémités extérieures des bras, et une jonction tunnel magnétique de sortie (100) est positionnée au point central de l'étoile.

12. Procédé (400) de fabrication d'un dispositif magnétique ou logique comprenant au moins deux piliers de jonction tunnel magnétique (100), le procédé comprenant :
- la fourniture (410) d'une couche de métal lourd (110), dans lequel la couche de métal lourd (110) comprend de l'Ir, du W, et/ou du Hf, et/ou du Pt, et/ou du Ta,
- la fourniture (420) d'une deuxième couche magnétique libre (120) au-dessus de la couche de métal lourd (110),
- la fourniture (430) d'une couche d'espaceur (130) sur la deuxième couche magnétique libre (120),
- la fourniture (440) d'une première couche magnétique libre (140) sur la couche d'espaceur (130),
- la fourniture (450) d'une couche de barrière tunnel (150) sur la première couche magnétique libre (140),
- la fourniture (460) d'une couche magnétique fixe (160) sur la couche de barrière tunnel (150),
- la structuration (470) de la couche magnétique fixe (160) de telle sorte que des portions de couche magnétique fixe (160a, 160b) des piliers de jonction tunnel magnétique (100) subsistent, subdivisant ainsi la deuxième couche magnétique libre (120) en portions de deuxième couche magnétique libre (120a, 120b) sous les portions de couche magnétique fixe (160a, 160b) et en une portion de deuxième couche magnétique libre d'interconnexion (120m) entre deux piliers de jonction tunnel magnétique (100), dans lequel les portions de deuxième couche magnétique libre (120a, 120b) sont des régions magnétiques hors plan,
**caractérisé par**
- une gravure par faisceau d'ions et/ou une irradiation ionique (480) entre les portions de couche magnétique fixe (160a, 160b) de telle sorte que la portion de deuxième couche magnétique libre d'interconnexion (120m) soit une couche magnétique libre dans le plan.

13. Procédé selon la revendication 12, procédé dans lequel la structuration est effectuée jusque dans la couche de barrière tunnel (150), voire jusque dans la première couche magnétique libre (140).

14. Utilisation d'un dispositif magnétique (200) selon l'une quelconque des revendications 1 à 9 ou d'un dispositif logique (300) selon l'une quelconque des revendications 10 ou 11, dans laquelle un transfert de couple de spin est utilisé pour piloter la commutation des portions de première (140a) et de deuxième (120a) couches magnétiques libres sous l'un des piliers de jonction tunnel magnétique (100), ce qui induit la commutation de la portion de deuxième couche libre d'interconnexion (120m) en raison du couplage chiral, et dans laquelle la magnétorésistance tunnel est utilisée pour lire une aimantation de la portion de première couche magnétique libre (140b) d'un autre des piliers de jonction tunnel magnétique (100).
